(19) Europäisches Patentamt / European Patent Office / Office européen des brevets

(11) **EP 4 130 190 A1**

(12) **EUROPEAN PATENT APPLICATION**
published in accordance with Art. 153(4) EPC

(43) Date of publication:
**08.02.2023 Bulletin 2023/06**

(21) Application number: **21781159.5**

(22) Date of filing: **17.03.2021**

(51) International Patent Classification (IPC):
***C09K 3/14*** (1968.09)   ***H01L 21/304*** (1974.07)

(52) Cooperative Patent Classification (CPC):
**C09K 3/14; H01L 21/304**

(86) International application number:
**PCT/JP2021/010795**

(87) International publication number:
**WO 2021/200148 (07.10.2021 Gazette 2021/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **30.03.2020   JP 2020060778**

(71) Applicant: **Fujimi Incorporated
Kiyosu-shi, Aichi 452-8502 (JP)**

(72) Inventor: **TAKAMI, Shinichiro
Kiyosu-shi, Aichi 452-8502 (JP)**

(74) Representative: **Grünecker Patent- und
Rechtsanwälte
PartG mbB
Leopoldstraße 4
80802 München (DE)**

(54) **POLISHING COMPOSITION**

(57)    Provided is a polishing composition that allows yielding a smooth surface comparable with or more than a surface produced by an abrasive-free polishing composition, and can be preferably used under both condition of low pressure and high pressure, in polishing of a hardness material. The polishing composition is a polishing composition for polishing a material having a Vickers hardness of 1500 Hv or more. The polishing composition contains particles and an oxidant, and the content of the particles is less than 400 ppm.

**Description**

[Technical Field]

The present invention relates to a polishing composition, particularly to a polishing composition preferable for polishing a high hardness material having a Vickers hardness of 1500 Hv or more. The application claims the priority based on Japanese Patent Application No. 2020-060778, filed on March 30, 2020, the content of which is herein incorporated by reference in its entirety.

[Background Art]

A surface of a material such as metal, semimetal, non-metal, or an oxide thereof is polished with a polishing composition. For example, a surface made of a compound semiconductor material, such as silicon carbide, boron carbide, tungsten carbide, silicon nitride, titanium nitride, or gallium nitride is processed by polishing (lapping), which is performed by supplying diamond abrasives between the surface and a polishing platen. However, lapping with diamond abrasives is prone to generate defects and strains due to generated or remaining scratches or dents, or the like. For this reason, exploration has been made for polishing with a polishing pad and a polishing composition, after lapping with diamond abrasives or instead of such lapping. Examples of literatures disclosing this kind of conventional technique include Patent Literatures 1 and 2. Patent Literature 1 describes that a silicon carbide substrate is polished with a polishing composition containing 0.1-30% by weight of abrasives. By contrast, Patent Literature 2 discloses that a silicon carbide substrate is polished an abrasive-free polishing composition.

[Citation List]

[Patent Literature]

[Patent Document 1] Japanese Patent Application Publication No. 2011-513991
[Patent Literature 2] WO2012/147605

[Summary of Invention]

[Technical Problem]

Generally, a polishing removal rate is required to be practically, sufficiently high in view of manufacturing efficiency, cost-effectiveness, and the like. For example, polishing of a surface made of a high hardness material such as silicon carbide has strongly required an improved polishing removal rate. The polishing removal rate for this kind of surface can be improved by increasing a load on a surface to be polished while polishing to gain a processing pressure. However, in use of a polishing composition containing abrasives as described in Patent Literature 1, an increase of processing pressure is prone to generate a polishing damage such as a scratch on a polishing surface and less likely to yield a smooth, flat surface. Moreover, a polishing composition containing a predetermined amount or more of abrasives tends to increase a friction coefficient between a polishing surface and a polishing pad while polishing.
For such problems in a polishing composition that contains abrasives, Patent Literature 2 proposes an abrasive-free polishing composition. However, when a polishing composition has no abrasive, an increase of processing pressure for a higher polishing removal rate potentially enlarges a friction coefficient between a polishing surface and a polishing pad, leading to break a wafer, a substrate.
The present invention was made in light of such circumstances, and has an objective to provide a polishing composition that can yield a smooth surface comparable with or more than a surface produced by an abrasive-free polishing composition in polishing of a high hardness material having a Vickers hardness of 1500 Hv or more, and can be preferably used in both conditions of low pressure and high pressure.

[Solution to Problem]

The description provides a polishing composition to polish a material having a Vickers hardness of 1500 Hv or more. This polishing composition contains particles and an oxidant, and the content of the particles is less than 400 ppm. In polishing of a high hardness material under low pressure, a small content, less than 400 ppm, of particles in a polishing composition yields a smooth polished surface comparable to use of an abrasive-free polishing composition.

Meanwhile, polishing under high pressure is accompanied by suppression of increase in polishing friction, reduction in a load on a polishing surface due to the friction, and prevention of breakdown of a wafer, a substrate. Furthermore, in polishing under high pressure, use of less than 400 ppm of particles also yields a polished surface having higher smoothness.

As used herein, "low (processing) pressure" refers to a pressure of less than 30 kPa, and "high (processing) pressure" refers to a pressure of 30 kPa or more (with an upper limit of about 150 kPa). Processing pressure as referred to herein is synonymous with polishing pressure.

In some preferred embodiments of the technologies disclosed herein (including polishing compositions, polishing methods, manufacturing methods of a substrate; the same applies hereinafter), the particles have a average aspect ratio of 1.5 or less. With a particle having a average aspect ratio of 1.5 or less, the particles preferably reduce friction between a polishing surface and a polishing pad under a condition of high pressure, and even in a condition of high pressure, stress on a polishing surface is low, thus a good balance between a high polishing removal rate and a high surface quality can be achieved.

In some preferred embodiments, silica particles are used as the particles. An effect from the technologies disclosed herein is preferably attained in composition containing silica particles as the particles. As the silica particles, colloidal silica is preferably used, for example.

In some preferred embodiments, the oxidant is permanganate. In polishing of a high hardness material, such composition facilitates improvement in a polishing removal rate, and achieves a good balance between a high polishing removal rate and a smooth polished surface.

In some preferred embodiments, the polishing composition further contains a metal salt A. In polishing of a high hardness material, such composition facilitates improvement in a polishing removal rate.

In some preferred embodiments, the material having a Vickers hardness of 1500 Hv or more is silicon carbide. In polishing of silicon carbide, an effect from the technologies disclosed herein is preferably exerted.

The description further provides a method for polishing a material having a Vickers hardness of 1500 Hv or more. The method includes a step of polishing the aforementioned material with any of the polishing compositions disclosed herein. In polishing of a high hardness material, this method allows yielding a smooth surface comparable with or more than a surface produced by an abrasive-free polishing composition, and may attain a less load on a polished surface and a high polishing removal rate under a condition of high pressure. A more highly smooth surface can also be yielded.

[Description of Embodiments]

Preferred embodiments of the present invention will be described below. Matters that are other than those particularly mentioned herein but are necessary for implementation of the present invention can be recognized as matters to be designed by those skilled in the art based on conventional technologies in the art. The present invention can be implemented based on contents disclosed herein and common technical knowledge in the art.

<Polishing Composition>

(Particle)

The polishing composition disclosed herein is characterized in that the polishing composition contains particles in a content of less than 400 ppm (which is the total content when containing a plurality kinds of particles). The term "ppm" as used herein refers to the weight (mg) of particles in 1 liter (L) of the polishing composition. In polishing of a high hardness material with low pressure, the polishing composition containing the aforementioned particles in a proportion of less than 400 ppm yields a smooth polished surface comparable to use of an abrasive-free polishing composition because a content of the particles which may cause a polishing damage is limited. Meanwhile, under a condition of high pressure, the particles slightly contained in the polishing composition are considered to function so as to suppress an increase of polishing friction with a polishing surface. As a result, stress on the polishing surface is reduced and breakdown of a wafer, a substrate is prevented. In addition, inclusion of the particles in an amount of less than 400 ppm in the polishing composition yields a highly smooth surface, in polishing of a high hardness material under both conditions of low pressure and high pressure. Note that effects from the technologies disclosed herein are not interpreted as limited merely to the aforementioned actions of the particles.

In view of reducing friction between a polishing surface and a polishing pad under a condition of high pressure, and improving a polishing removal rate, the content of the particles in the polishing composition can be 0.01 ppm or more, may be e.g., 0.1 ppm or more, is suitably 1 ppm or more, may be 5 ppm or more, may be 10 ppm or more, is preferably 20 ppm or more, more preferably 40 ppm or more, even more preferably 60 ppm or more, and particularly preferably 70 ppm or more (e.g., 80 ppm or more), and may be 90 ppm or more. In view of further improving a polishing removal rate, the polishing composition disclosed herein can be preferably provided even in an embodiment where the content of the particles is 120 ppm or more, 170 ppm or more, 220 ppm or more, or 270 ppm or more. Moreover, in view of achieving a smooth polished surface, the content of the particles may be 350 ppm or less, 300 ppm or less, 250 ppm or less, 200 ppm or less, 150 ppm or less, 100 ppm or less, 95 ppm or less, 85 ppm or less, 65 ppm or less, or 30 ppm or less.

The material, properties, and the like of the particles are not particularly limited as long as an effect of the present invention is exerted. For example, the particles may be any of inorganic particles, organic particles, and organic-inorganic composite particles. Examples of the inorganic particles include particles substantially including any of the following: oxide particles such as silica particles, alumina particles, cerium oxide particles, chromium oxide particles, titanium dioxide particles, zirconium oxide particles, magnesium oxide particles, manganese dioxide particles, zinc oxide particles, and iron oxide particles; nitride particles such as silicon nitride particles and boron nitride particles; carbide particles such as silicon carbide particles and boron carbide particles; diamond particles; carbonates such as calcium carbonate and barium carbonate; and the like. Examples of the organic particles include particles substantially made of any of cross-linked or non-cross-linked polymethyl methacrylate, polyacrylonitrile, polystyrene, nylon, silicone, and the like. The particles may be used singly or in combination of two or more kinds thereof. In particular, preferred are oxide particles such as silica particles, alumina particles, cerium oxide particles, chromium oxide particles, zirconium oxide particles, manganese dioxide particles, iron oxide particles, and magnesium oxide particles, because of their ability to form a good surface; more preferred are silica particles, alumina particles, cerium oxide particles, and manganese dioxide particles; and particularly preferred is silica particles in view of reducing friction between a polishing surface and a polishing pad and improving smoothness of a polished surface. Moreover, when the polishing composition contains organic particles, such particles are preferably particles substantially made of any of polystyrene, nylon, and the like.

Examples of the silica particles include colloidal silica, fumed silica and precipitated silica. In view of improving smoothness, the silica particles are preferably colloidal silica and fumed silica. In view of reducing friction between a polishing surface and a polishing pad, colloidal silica is particularly preferable.

The true specific gravity (true density) of the silica particles is preferably 1.5 or more, more preferably 1.6 or more, and even more preferably 1.7 or more. Increase in the true specific gravity of the silica particles leads to tendency to a higher physical ability for polishing. The upper limit of the true specific gravity of the silica particles are not particularly limited, but typically 2.3 or less, e.g., 22 or less, 2.0 or less, and 1.9 or less. As the true specific gravity of the silica particle, a measured value can be employed by a liquid displacement method using ethanol as a displacing liquid.

The average primary particle diameter of the particles (preferably silica particles) is not particularly limited. In view of reducing friction between a polishing surface and a polishing pad, and improving a polishing removal rate, the average primary particle diameter of the particles can be 5 nm or more, is suitably 10 nm or more, preferably 20 nm or more, and more preferably 30 nm or more, and may be e.g., 40 nm or more or 50 nm or more. In addition, the average primary particle diameter of the particles can be approximately 1000 nm or less, and is suitably 500 nm or less. In view of achieving a smooth polished surface, the average primary particle diameter of the particles is preferably 300 nm or less, more preferably 200 nm or less, even more preferably 100 nm or less. In some embodiments, the average primary particle diameter of the particles may be 80 nm or less, less than 70 nm, or less than 50 nm.

The average primary particle diameter as used herein refers to a particle diameter (BET particle diameter) calculated from a specific surface area measured by a BET method (BET value) by the formula: average primary particle diameter (nm) = $6000/(\text{true density (g/cm}^3) \times \text{BET value (m}^2/\text{g}))$. The specific surface area can be measured using e.g., a surface area measurement device with the product name of "Flow Sorb II 2300", manufactured by Micromeritics Instrument Corporation.

The average secondary particle diameter of the particles (preferably silica particles) is not particularly limited. In view of reducing polishing friction and improving a polishing removal rate, the average secondary particle diameter of the particles can be 20 nm or more, is suitably 40 nm or more, and preferably 50 nm or more. In some embodiments, the average secondary particle diameter of the particles may be, e.g., 70 nm or more, 90 nm or more, or 100 nm or more. In addition, the average secondary particle diameter of the particles can be approximately 1000 nm or less, and is suitably 500 nm or less. In view of achieving a smooth polished surface, the average secondary particle diameter of the particles is preferably 300 nm or less, more preferably 200 nm or less, even more preferably 150 nm or less. In some embodiments, the average secondary particle diameter of the particles may be 110 nm or less, 80 nm or less, or 65 nm or less.

The average secondary particle diameter of the particles, can be measured as the volume average particle diameter by dynamic light scattering, using, e.g., model "UPA-UT151" manufactured by Nikkiso Co., Ltd.

The shape (outer shape) of the particles is preferably globular. Without limitation, the average value of the major axis/minor axis ratios of the particles (average aspect ratio) is theoretically 1.00 or more, and may also be e.g., 1.05 or more or 1.10 or more in view of improving a polishing removal rate. Moreover, the average aspect ratio of the particles is suitably 3.0 or less, and may be 2.0 or less. In view of reducing friction between a polishing surface and a polishing pad, the average aspect ratio of the particles is preferably 1.50 or less, and may be 1.30 or less or 1.20 or less. The particles having the average aspect ratio as described above have other advantages in view of improving smoothness of a polished surface, reducing scratches, and the like.

The shape (outer shape), average aspect ratio, and the like of the particles can be acquired with, e.g., an electron microscopy. A specific procedure for acquiring the average aspect ratio can be, for example, extracting shapes of a predetermined number (e.g., 200) of the particles using a scanning electron microscope (SEM); drawing a minimum rectangle circumscribed to a shape of each of the extracted particles; then calculating, as a major axis/minor axis ratio (aspect ratio), a value by dividing the long side length (major axis value) by the short side length (minor axis value) for the rectangle drawn for the shape of each of the particles; and deriving the average aspect ratio from an arithmetic average of the aspect ratios for the predetermined number of the particles.

In an embodiment where the polishing composition contains silica particles as the particles, the polishing composition may further contain particles made of a material other than the silica described above (hereinafter also referred to as non-silica particles). Examples of such non-silica particles include particles substantially including any of the following: oxide particles such as alumina particles, cerium oxide particles, chromium oxide particles, titanium dioxide particles, zirconium oxide particles, magnesium oxide particles, manganese oxide particles, zinc oxide particles, and iron oxide particles; nitride particles such as silicon nitride particles and boron nitride particles; carbide particles such as silicon carbide particles and boron carbide particles; diamond particles; carbonates such as calcium carbonate and barium carbonate; and the like.

The polishing composition disclosed herein may not substantially contain diamond particles as the particles. Diamond particles have a high hardness and thus can be a factor for limited improvement in smoothness. Diamond particles are also generally expensive and thus not necessarily a beneficial material in terms of cost performance, and there may be less dependence on high-price materials such as diamond particles in terms of practical use. The particles not substantially containing diamond particles, as used herein, means that the proportion of diamond particles in all the particles is 1% by weight or less, including a case where the proportion of diamond particles is 0% by weight. In such an embodiment, an application effect of the present invention can be preferably exerted.

(Oxidant)

The polishing composition disclosed herein contains an oxidant. The oxidant can exhibit an effect to improve a polishing removal rate in polishing of a high hardness material (e.g., silicon carbide). The technologies disclosed herein allows attaining a higher polishing removal rate with use of an appropriate amount of the oxidant, in composition having a limited content of the particles such as silica particles. Specific examples of the oxidant include peroxides such as hydrogen peroxide; nitric acid compounds including nitric acid, salts thereof such as iron nitrate, silver nitrate, and aluminum nitrate, and complexes thereof such as ceric ammonium nitrate; persulfuric acid compounds including persulfuric acids such as peroxomonosulfuric acid and peroxodisulfuric acid, and salts thereof such as ammonium persulfate and potassium persulfate; chlorine compounds including chloric acid and salts thereof, and perchloric acid and salts thereof such as potassium perchlorate; bromine compounds including bromic acid and salts thereof such as potassium bromate; iodine compounds including iodic acid and salts thereof such as ammonium iodate, and periodic acid and salts thereof such as sodium periodate and potassium periodate; ferrates including ferric acid and salts thereof such as potassium ferrate; permanganates including permanganic acid and salts thereof such as sodium permanganate and potassium permanganate; chromates including chromic acid and salts thereof such as potassium chromate and potassium dichromate; vanadates including vanadic acid and salts thereof such as ammonium vanadate, sodium vanadate, and potassium vanadate; ruthenates including perruthenic acid and salts thereof; molybdates including molybdic acid and salts thereof such as ammonium molybdate and disodium molybdate; rhenates including perrhenic acid and salts thereof; and tungstates including tungstic acid and salts thereof such as disodium tungstate. The oxidant can be used singly or in combination of two or more kinds thereof.

In some preferred embodiments, the polishing composition contains a composite metal oxide as the oxidant. Specific examples of the composite metal oxide include nitrate metal salts such as iron nitrate and silver nitrate; ferrates such as potassium ferrate; permanganates such as sodium permanganate and potassium permanganate; chromates such as potassium chromate and potassium dichromate; vanadates such as sodium vanadate and potassium vanadate; ruthenates such as salts of perruthenic acid; molybdates such as ammonium molybdate and disodium molybdate; rhenates such as salts of perrhenic acid; and tungstates such as disodium tungstate. In particular, permanganate is particularly preferably used. Inclusion of permanganate in the polishing composition preferably improves a polishing removal rate. The composite metal oxides can be used singly or in combination of two or more kinds thereof.

In particularly preferred embodiments, a composite metal oxide containing a monovalent or divalent metal element (other than transition metal elements) and a fourth-row transition metal element in the periodic table is used as the composite metal oxide described above. Preferred examples of the monovalent or divalent metal element include Na, K, Mg, and Ca. In particular, Na and K are more preferable. Preferred examples of the fourth-row transition metal element in the periodic table include Fe, Mn, Cr, V, and Ti. In particular, Fe, Mn, and Cr are more preferable, and Mn is even more preferable. The composite metal oxide is useful in reducing hardness of a high hardness material such as silicon carbide and making the material fragile. This improves a polishing removal rate more preferably.

When the composite metal oxide is a salt (e.g., a permanganate), the composite metal oxide may be present in an ionic state in the polishing composition.

The polishing composition disclosed herein may or may not further contain an oxidant other than the composite metal oxide. The technologies disclosed herein can be preferably performed in a mode where an oxidant other than the composite metal oxide (e.g., hydrogen peroxide) is not substantially contained as the oxidant.

The content of the oxidant in the polishing composition is usually suitably 0.005 mol/L or more. In view of improving a polishing removal rate, the content of the oxidant is preferably 0.008 mol/L or more, and more preferably 0.01 mol/L or more, and may be 0.03 mol/L or more, 0.05 mol/L or more, 0.06 mol/L or more, or 0.07 mol/L or more. In view of improving a surface quality after polishing, the content of the oxidant in the polishing composition is usually suitably 0.5 mol/L or less, preferably 0.3 mol/L or less, and more preferably 0.2 mol/L or less, and may be 0.1 mol/L or less, or 0.09 mol/L or less.

(Water)

The polishing composition disclosed herein contains a liquid (liquid medium at 23°C) commonly referred to as a dispersion medium or a solvent. The kind thereof is appropriately set corresponding to the kind of the particles, a material to be polished, a mode of use thereof, or the like and is not limited to certain kinds. In a typical embodiment, the polishing composition may contain water. As water, ion-exchange water (deionized water), pure water, ultrapure water, distilled water, or the like can be preferably used. The polishing composition disclosed herein may further contain an organic solvent (lower alcohol, lower ketone, or the like) that can be uniformly mixed with water, as necessary. Usually, it is appropriate that 90 vol% or more of the solvent contained in the polishing composition is water, it is preferable that 95 vol% or more thereof is water, and it is more preferable that 99 to 100 vol% thereof is water.

(Acid)

The polishing composition can contain an acid as necessary, for the purpose of pH adjustment, improvement in a polishing removal rate, and the like. As the acid, both inorganic and organic acids can be used. Examples of the inorganic acids include sulfuric acid, nitric acid, hydrochloric acid, and carbonic acid. Examples of the organic acids include aliphatic carboxylic acids such as formic acid, acetic acid and propionic acid; aromatic carboxylic acids such as benzoic acid and phthalic acid; citric acid; oxalic acid; tartaric acid; malic acid; maleic acid; fumaric acid; succinic acid; organic sulfonic acid; and organic phosphonic acid. These can be used singly or in combination of two or more kinds thereof. When using an acid, the amount to be used is not particularly limited, and can be set according to the purpose of use (e.g., pH adjustment). Alternatively, in some embodiments of the polishing composition disclosed herein, the composition may contain substantially no acid.

(Basic Compound)

The polishing composition can contain a basic compound as necessary, for the purpose of pH adjustment, improvement in a polishing removal rate, and the like. The basic compound as used herein refers to a compound that has a function to raise pH of the polishing composition by being added to the composition. Examples of the basic compound include alkali metal hydroxides such as potassium hydroxide and sodium hydroxide; carbonates or hydrogencarbonates such as ammonium bicarbonate, ammonium carbonate, potassium bicarbonate, potassium carbonate, sodium bicarbonate, and sodium carbonate; ammonia; quaternary ammonium compounds including quaternary ammonium hydroxides such as tetramethylammonium hydroxide, tetraethylammonium hydroxide, and tetrabutylammonium hydroxide; others, such as amines, phosphates and hydrogen phosphates, and organic acid salts. The basic compounds can be used singly or in combination of two or more kinds thereof. In use of the basic compound, the amount to be used is not particularly limited, and can be set according to the purpose of use (e.g., pH adjustment). Alternatively, in some embodiments of the polishing composition disclosed herein, the composition may contain substantially no basic compound.

(Metal Salt A)

The polishing composition disclosed herein can contain at least one kind of metal salt A selected from the group consisting of alkali metal salts and alkaline-earth metal salts, for the purpose of improving a polishing removal rate or the like. In polishing, the oxidant degenerates a surface to be polished (particularly, a surface of a high hardness material such as silicon carbide), and the degenerated layer is removed by friction with the particles and a polishing pad. Metal salt A exhibits a catalytic action that promotes the degeneration and removal, and is considered to contribute to improvement in a polishing removal rate. As used herein, a degenerated layer refers to, e.g., a layer including an oxide film, and a catalytic action refers to, e.g., an action to dissolve an oxide film. However, limited interpretation should not be made only to the reasons described above. Metal salt A preferably typically contains any one kind or two kinds of lithium (Li), sodium (Na), potassium (K), rubidium (Rb), cesium (Cs), magnesium (Mg), calcium (Ca), strontium (Sr), and barium (Ba) as an element(s) belonging to alkali metal or alkaline-earth metal. In particular, any of Na, K, Ca, and Sr is preferable. In some embodiments, metal salt A is an alkali metal salt. An alkali metal salt is less likely to generate aggregation of the particles originated from ions of the metal thereof. This can provide better polishing characteristics in the polishing composition containing the particles. Meanwhile, in some embodiments, the metal salt A is an alkaline-earth metal salt. An alkaline-earth metal salt is less diffusive in an ionic form, and enables reduction in metallic contamination in a polished surface. This allows achieving a better polished object.

The kind of a salt in metal salt A as described above is not particularly limited, and may an inorganic acid salt or an organic acid salt. Examples of the inorganic acid salt include salts of hydrohalic acid such as hydrochloric acid, hydrobromic acid, and hydrofluoric acid; nitric acid; sulfuric acid; carbonic acid; silicic acid; boric acid; phosphoric acid; and the like. In addition, examples of the organic acid salt include salts of carboxylic acids such as formic acid, acetic acid, propionic acid, benzoic acid, glycine acid, butyric acid, citric acid, tartaric acid, and trifluoroacetic acid; organic sulfonic acids such as methanesulfonic acid, trifluoromethanesulfonic acid, benzenesulfonic acid, and toluenesulfonic acid; organic phosphonic acids such as methylphosphonic acid, benzenephosphonic acid, and toluenephosphonic acid; organic phosphoric acid such as ethylphosphoric acid; and the like. In particular, preferred is salts of hydrochloric acid, nitric acid, sulfuric acid, silicic acid, boric acid, and phosphoric acid, and more preferred is salts of hydrochloric acid and nitric acid.

Specific examples of metal salt A include the one substantially formed of any of the following: chlorides such as chloride lithium, sodium chloride, potassium chloride, magnesium chloride, calcium chloride, strontium chloride, and barium chloride; bromides such as sodium bromide, potassium bromide, and magnesium bromide; fluorides such as lithium fluoride, sodium fluoride, potassium fluoride, magnesium fluoride, calcium fluoride, strontium fluoride, and barium fluoride; nitrates such as lithium nitrate, sodium nitrate, potassium nitrate, magnesium nitrate, calcium nitrate, strontium nitrate, and barium nitrate; sulfates such as lithium sulfate, sodium sulfate, potassium sulfate, magnesium sulfate, calcium sulfate, strontium sulfate, and barium sulfate; carbonates such as potassium carbonate, potassium hydrogencarbonate, sodium carbonate, sodium hydrogencarbonate, magnesium carbonate, calcium carbonate, strontium carbonate, and barium carbonate; borates such as sodium borate; carboxylates such as potassium acetate, sodium acetate, calcium acetate, strontium acetate, sodium benzoate, calcium benzoate, sodium citrate, and calcium citrate. Such metal salts A may be used singly or in combination of two or more kinds thereof.

Metal salt A is preferably a water-soluble salt. Use of a water-soluble metal salt A can efficiently form a good surface with less defects such as a scratch. In a preferred embodiment, metal salt A may be a salt that exhibits a neutral range in an aqueous solution where the metal salt A is dissolved in water, typically a normal salt that generates by neutralization between a strong acid and a strong base. Use of metal salt A that exhibits neutrality in an aqueous solution can cause efficient formation of a high-quality surface with further reduced defects such as a scratch. Neutral range as referred to herein means that, for example, a pH of 4 or more to 9 or less, preferably a pH of 4 or more to 8 or less (in a 5% aqueous solution at 25°C). Examples of metal salt A that exhibits neutrality in an aqueous solution include chlorides such as sodium chloride, potassium chloride, calcium chloride, and strontium chloride; and nitrates such as sodium nitrate, potassium nitrate, calcium nitrate, and strontium nitrate. In particular, calcium chloride, strontium chloride, potassium chloride, sodium chloride, and calcium nitrate are preferable because they can efficiently form a good surface. In some embodiments, metal salt A is a chloride or nitrates of an alkali metal. Additionally, in some embodiments, metal salt A is a chloride or nitrate of an alkaline-earth metal.

The concentration (content) C1 of metal salt A in the polishing composition is not particularly limited, but is usually suitably 10 mol/L or less. Lowering the concentration C1 of the metal salt A may improve a polishing removal rate at a higher level in polishing of a high hardness material. In view of a polishing removal rate and the like, the concentration C1 is suitably 10 mol/L or less, preferably 8 mol/L or less, and more preferably 6 mol/L or less, e.g., 3 mol/L or less or 1.5 mol/L or less. In some embodiments, the concentration C1 of metal salt A may be 1 mol/L or less, or may be 0.5 mol/L or less, e.g., 0.1 mol/L or less, and typically 0.05 mol/Lor less. The lower limit of the concentration C1 is suitably 0.0001 mol/L or more, preferably 0.0005 mol/L or more, more preferably 0.001 mol/L or more, and even more preferably 0.003 mol/L or more. The concentration C1 may be, e.g., 0.0035 mol/L or more, 0.005 mol/L or more, or 0.01 mol/L or more. The technologies disclosed herein may be preferably performed in an embodiment where the concentration C1 of metal salt A in the polishing composition is, e.g., 0.003 mol/L to 1.5 mol/L or 0.0035 mol/L to 1 mol/L.

Without limitation, in view of allowing further exertion of an effect of combination of the oxidant and metal salt A, the ratio (C1/C2) of the concentration C1 of metal salt A in the polishing composition (which is the total concentration when containing a plurality of metal salts A) [mol/L] versus the concentration C2 of the oxidant (which is the total concentration when containing a plurality of the oxidants) [mol/L] is preferably 0.001 or more, more preferably 0.005 or more, even more preferably 0.01 or more, and particularly preferably 0.02 or more in view of facilitating exertion of an effect provided by the present invention. In some embodiments, C1/C2 may be, e.g., 0.08 or more, or typically 0.12 or more. The upper limit of C1/C2 is not particularly limited, but is generally preferably 100 or less. The C1/C2 is typically 70 or less, preferably 30 or less, more preferably 10 or less, even more preferably 1 or less, and particularly preferably 0.5 or less. In some embodiments, C1/C2 may be, e.g., 0.3 or less. Such ratios of concentrations of metal salt A and the oxidant (C1/C2) may preferably improve a polishing removal rate.

(Other components)

The polishing composition disclosed herein may further contain, as necessary, a known additive that can be used for polishing compositions (e.g., a polishing composition used for polishing a high hardness material such as silicon carbide), such as a chelating agent, a thickener, a dispersant, a surface protective agent, a wetting agent, a surfactant, a corrosion inhibitor, an antiseptic agent, or an antifungal agent, as long as an effect of the present invention is not impaired. Since the content of the additive only has to be appropriately set according to the purpose of addition thereof and does not characterize the present invention, a detailed description thereof will be omitted.

(pH)

The pH of the polishing composition is usually suitably about 2 to 12. The pH within the range facilitates achievement of a practical polishing removal rate. In some embodiments, the pH may be 2.0 or more, 2.5 or more, 3.0 or more, 4.0 or more, 5.0 or more, or 5.5 or more. The upper limit of the pH is not particularly limited, but in some embodiments, the pH may be 12.0 or less, 10.0 or less, 9.0 or less, less than 9.0, 8.0 or less, less than 8.0, 7.0 or less, less than 7.0, 6.0 or less, or less than 6.0. In some embodiments, the pH may be 5.0 or less, less than 5.0, 4.0 or less, or less than 4.0.

A method for preparing the polishing composition disclosed herein is not particularly limited. For example, each component to be contained in the polishing composition may be mixed using a well-known mixing device such as a blade stirrer, an ultrasonic disperser, or a homomixer. An embodiment for mixing these components is not particularly limited, and, for example, all components may be mixed at once or in an appropriately set order.

The polishing composition disclosed herein may be a single-agent type or a multi-agent type such as a two-agent type. For example, the composition may be configured to be used for polishing an object to be polished, by mixing of Part A, which contains a part of components of the polishing composition (e.g., a component other than water), and Part B, which contains the remaining components. These components may be, for example, separated and stored before use, and then mixed in use to prepare the polishing composition in a single liquid. In mixing, dilution water and the like may be further mixed.

<Object to be Polished>

The polishing composition disclosed herein is preferable for polishing a material having a Vickers hardness of 1500 Hv or more (also referred to as a high hardness material). The polishing composition disclosed herein allows yielding a highly smooth surface for such a high hardness material, under both conditions of low pressure and high pressure. The Vickers hardness of a high hardness material is preferably 1800 Hv or more (e.g. 2000 Hv or more, and typically 2200 Hv or more). The upper limit of the Vickers hardness is not particularly limited, and may be about 7000 Hv or less (e.g. 5000 Hv or less, and typically 3000 Hv or less). The Vickers hardness herein can be measured based on JIS R 1610:2003. The international standard corresponding to the aforementioned JIS standard is ISO 14705:2000.

Examples of materials having a Vickers hardness of 1500 Hv or more include diamond, sapphire (aluminum oxide), silicon carbide, boron carbide, tungsten carbide, silicon nitride, and titanium nitride. The polishing composition disclosed herein can be preferably applied to a single crystal surface of the aforementioned material. In particular, a polished surface is preferably made of silicon carbide. Silicon carbide is expected to be a semiconductor material with less power loss, excellent heat resistance and the like, and improvement in the surface thereof has especially great advantage in practical use. The polishing composition disclosed herein is particularly preferably applied to a single crystal silicon carbide surface.

Such a high hardness material in the technologies disclosed herein typically has a substrate form, which may be a form referred to as a wafer. The thickness of such a substrate is suitably set corresponding to the size (such as diameter) and the like. The thickness of the substrate is usually approximately 100 $\mu$m or more, suitably approximately 300 $\mu$m or more (e.g., approximately 350 $\mu$m or more), and may be e.g., approximately 500 $\mu$m or more. Moreover, the thickness is usually approximately 1500 $\mu$m or less, suitably approximately 1000 $\mu$m or less, and preferably approximately 800 $\mu$m or less, may be e.g., approximately 500 $\mu$m or less (typically less than 500 $\mu$m), and may be approximately 400 $\mu$m or less. In polishing of a substrate of a high hardness material having such a thickness, an effect from the technologies disclosed herein (prevention of breakdown or the like of the substrate) is preferably attained.

<Polishing Method>

The polishing composition disclosed herein can be used for polishing a substrate of a high hardness material in an exemplary embodiment including the following operations.

That is, a polishing slurry (slurry) containing any of the polishing compositions disclosed herein is prepared. Preparation of the polishing slurry may include preparing the polishing slurry by subjecting the polishing composition to operations such as concentration adjustment (e.g., dilution) and pH adjustment. Alternatively, the polishing composition may be directly used as a polishing slurry. In use of a multi-agent type polishing composition, preparation of the polishing slurry may include mixing the agents thereof, diluting one or more of the agents before the mixing, diluting the resulting mixture after the mixing, and the like.

Next, the polishing slurry is supplied to a substrate, and subjected to polishing by a common method performed by those skilled in the art. For example, one method is to set a substrate in a common polishing machine, and supplying the polishing slurry to a polishing surface of the substrate through a polishing pad of the polishing machine. Typically, while supplying the polishing slurry continuously, the polishing pad is pressed against the polishing surface of the substrate, and both of the surface and the pad are moved (e.g., rotated) relative to each other. Polishing of the substrate is completed through such a polishing step.

The description provides a method for polishing a high hardness material and a method for producing a substrate of a high hardness material using the method. The polishing method is characterized by including a step of polishing a substrate using the polishing composition disclosed herein. A polishing method according to some preferred embodiments includes a step of performing preliminary polishing (preliminary polishing step) and a step of performing final polishing (final polishing step). In some embodiments, the preliminary polishing step is a polishing step set immediately before the final polishing step. The preliminary polishing step may be a single-step polishing step or a polishing step including two or more sub-steps. The final polishing step as referred to herein designates a step of applying final polishing to a substrate that has been subjected to preliminary polishing, specifically, a polishing step set at the end (i.e., on the most downstream) of polishing steps performed with a polishing slurry containing abrasives or the like. In such a polishing method including the preliminary polishing step and the final polishing step, the polishing composition disclosed herein may be used at a step in the preliminary polishing step, may be used in the final polishing step, or may be used in both of the preliminary polishing step and the final polishing step.

The preliminary polishing and the final polishing can be performed using both of a single-side polishing machine and a double-side polishing machine. In a single-side polishing machine, one side of a substrate is polished by attaching the substrate to a ceramic plate with wax, holding the substrate with a holder called a carrier, and then pressing a polishing pad against one side of the substrate and moving both relative to each other with supplying a polishing composition. This movement is, e.g., rotational movement. In a double-side polishing machine, both sides of a substrate are polished simultaneously by holding the substrate with a holder called a carrier, and then pressing polishing pads against opposing sides of the substrate and moving them relative to one another with supplying a polishing composition from above.

Conditions of the polishing as described above is appropriately set on the basis of the kind of a material to be polished, the target of surface properties (particularly, smoothness), a polishing removal rate, or the like, and thus is not limited to particular conditions. For example, in terms of polishing pressure, polishing with the polishing composition disclosed herein can yield a high polishing removal rate and a highly smooth face in both conditions of low pressure and high pressure, and thus is not limited to particular conditions. The polishing composition disclosed herein can be used in a wide range of pressure such as 10 kPa or more to 150 kPa or less. More particularly, the polishing composition disclosed herein can not only be preferably used for polishing under a low pressure condition such as 10 kPa or more to less than 30 kPa, but also, even under a high pressure condition such as 30 kPa or more to 150 kPa or less, sufficiently yield a polished surface having higher smoothness of a high hardness material, with suppressing a load on a polishing surface and preventing breakdown or the like of a substrate. In some preferred embodiments, the polishing composition disclosed herein can attain a more excellent effect in polishing under the high pressure condition.

The polishing pad used in each polishing step disclosed herein is not particularly limited. For example, any of a non-woven fabric type, a suede type, and a hard foamed polyurethane type may be used. In some embodiments, a suede-type polyurethane polishing pad, a hard foamed polyurethane type polishing pad, or the like is used, and a hard foamed polyurethane type polishing pad may be preferably employed. In an embodiment using the polishing pad described above, an effect to reduce friction between a polishing surface and a polishing pad, which is an effect provided by the technologies disclosed herein, is preferably exerted. The polishing pad used in the technologies disclosed herein is an abrasive-free polishing pad.

A substrate polished by the method disclosed herein is typically cleaned after polishing. The cleaning can be performed using a suitable cleaning solution. The cleaning solution to be used is not particularly limited, and a known or conventional cleaning solution can be appropriately selected and used.

The polishing method disclosed herein may include any other step in addition to the preliminary polishing step and final polishing step described above. Examples of such a step include a mechanical polishing step, a lapping step, and the like performed before the preliminary polishing step. In the mechanical polishing step, a substrate is polished with a liquid of diamond abrasives dispersed in a solvent. In some preferred embodiments, the dispersion contains no oxidant. The lapping step is a step of polishing with pressing a surface of a polishing platen, such as a cast iron platen, to a substrate. Therefore, in the lapping step, no polishing pad is used. The lapping step is typically performed by supplying abrasives between a polishing platen and a substrate. The abrasives are typically diamond abrasives. In addition, the polishing method disclosed herein may include an additional step before the preliminary polishing step or between the preliminary polishing step and the final polishing step. The additional step is, for example, a cleaning step or a polishing step.

The arithmetic average surface roughness Ra of a surface after polishing with the polishing composition disclosed herein may vary depending on an intended use of a substrate, the kind of a material to be polished, a stage in polishing, and the like, and thus is not limited in a particular range. The Ra of a polished surface is suitably about 10 nm or less, for example. In some preferred embodiments, the Ra of a polished surface is 1 nm or less, more preferably less than 0.1 nm, and even more preferably less than 0.05 nm. The technologies disclosed herein allow yielding a substrate having a highly smooth surface as described above. The Ra of a surface of a polished face (polished surface) of a substrate is measured by a method described later in the examples.

<Production Method of Substrate>

The technologies disclosed herein may include provision of a method for producing a substrate that includes a polishing step with use of any of the polishing methods described above and a substrate produced by the method. The production method of a substrate is, for example, a method for producing a silicon carbide substrate. That is, the technologies disclosed herein provide a method for producing a substrate that includes polishing a substrate made of a high hardness material by applying any of the polishing methods disclosed herein, and provide a substrate produced by the method. The production method described above can efficiently provide a substrate, such as a silicon carbide substrate, having improved surface quality can be efficiently provided.

[Examples]

Several examples relating to the present invention will be described below, but the present invention is not intended to be limited to embodiments shown in the examples. In the following description, "%" is on a weight basis unless otherwise specified.

<Preparation of Polishing Composition>

(Examples 1 to 6 and Comparative Examples 1 and 2)

Particles, an oxidant, and deionized water (DIW) were mixed to prepare a polishing composition according to each example. Colloidal silica having an average primary particle diameter of 43 nm (with an average secondary particle diameter of 57 nm) was used as the particles, and potassium permanganate ($KMnO_4$) was used as the oxidant. The content of the particles in the polishing composition was a content shown in Table 1, and the concentration of potassium permanganate was 0.08 mol/L. In addition, the pH of the polishing composition was 3.0 using nitric acid.

(Examples 7 to 9)

Particles, an oxidant, a metal salt, and deionized water (DIW) were mixed to prepare a polishing composition according to each example. Colloidal silica having an average primary particle diameter of 43 nm (with an average secondary particle diameter of 57 nm) was used as the particles; potassium permanganate ($KMnO_4$) was used as the oxidant; and calcium nitrate was used as the metal salt. The content of the particles in the polishing composition was a content shown in Table 2; the concentration of potassium permanganate was 0.08 mol/L; and the concentration of ium nitrate was 0.0125 mol/L. In addition, the pH of the polishing composition was 3.0 using nitric acid.

<Polishing of Substrate>

A SiC wafer was preliminarily polished with a preliminary polishing composition containing alumina abrasives. The preliminarily polished surface was polished under the polishing conditions described below, by directly using the polishing composition of each of the examples as a polishing slurry. Polishing was performed under two conditions, low pressure and high pressure, as follows.

[Polishing Conditions]

Polishing machine: model "RDP-500", manufactured by Fujikoshi Machinery Corp.
Polishing pad: "SUBA800XY", manufactured by Nitta Haas Incorporated.
Polishing pressure: (low pressure) 19.6 kPa
(high pressure) 39.2 kPa.
Supply rate of polishing slurry: 20 mL/min.
Platen rotational speed: 100 revolutions/min.
Head rotational speed: 100 revolutions/min.
Polishing time: 1 hour.
Substrate: SiC wafer (conduction type: n-type, crystalline type: 4H-SiC, off angle to the C-axis of the main surface (0001): 4°), 2 inches, 1 sheet/batch.
Temperature of polishing slurry: 23°C.

<Evaluation of Polishing Removal Rate>

A SiC wafer was polished with the polishing composition of each of the examples under the polishing conditions described above, and then a polishing removal rate was calculated in accordance with the formulae (1) and (2). In corresponding columns in Tables 1 and 2, each polishing removal rate is described as a ratio given that the polishing removal rate of Comparative Example 1 under low pressure is defined as 100.

$$(1)\ \text{Polishing removal [cm]} = \text{difference in weight of SiC wafer before and after polishing}$$

$$[\text{g}]/\text{density of SiC [g/cm}^3]\ (= 3.21\ \text{g/cm}^3)/\text{polishing target area [cm}^2]\ (= 19.62\ \text{cm}^2)$$

$$(2)\ \text{Polishing removal rate [nm/h]} = \text{polishing removal [cm]} \times 10^7/\text{polishing time} (= 1\ \text{hour})$$

< Evaluation of Friction Coefficient>

Measurement was made for a friction coefficient between a polished surface and a polishing pad in polishing a SiC wafer with the polishing composition of each of the examples under the polishing conditions described above. As the friction coefficient described above, a value output from the polishing machine was employed directly. The friction coefficient was a measured value derived by employing a template in which a suede backing material is used as a wafer holder part, and attaching a wafer so that a protruding height of the wafer was 200 $\mu$m or more to keep the wafer attaching onto the suede material with water, in the polishing. In corresponding columns in Tables 1 and 2, each friction coefficient is described as a ratio given that the friction coefficient of Comparative Example 1 under low pressure is defined as 100.

<Smoothness>

A SiC wafer was polished with the polishing composition of each of the examples under the polishing conditions, and then evaluated with smoothness of the polished surface as follows. For the evaluation of smoothness, an atomic force microscope (AFM; model "XE-HDM", manufactured by Park Systems Corporate) was used. In particular, surface roughness Ra (nm) was measured for 22 points within a wafer surface under a condition of a measurement field of 10 $\mu$m × 10 $\mu$m, and subjected to calculation of an average value thereof. Note that corresponding columns in Tables 1 and 2 describes results evaluated as "passed" for an arithmetic average surface roughness Ra (nm) of less than 0.05 nm, and as "failed" for a Ra of 0.05 nm or more.

[Table 1]

Table 1

| | Particle | | Oxidant | | Friction coefficient (relative value) | | Polishing removal rate (relative value) | | Surface roughness | |
|---|---|---|---|---|---|---|---|---|---|---|
| | Type | Content [ppm] | Species | Concentration [mol/L] | Low pressure | High pressure | Low pressure | High pressure | Low pressure | High pressure |
| Example 1 | Silica | 80 | $KMnO_4$ | 0.08 | 95 | 150 | 120 | 260 | Passed | Passed |
| Example 2 | Silica | 50 | $KMnO_4$ | 0.08 | 95 | 180 | 120 | 240 | Passed | Passed |
| Example 3 | Silica | 10 | $KMnO_4$ | 0.08 | 100 | 200 | 110 | 220 | Passed | Passed |
| Example 4 | Silica | 1 | $KMnO_4$ | 0.08 | 100 | 200 | 110 | 220 | Passed | Passed |
| Example 5 | Silica | 200 | $KMnO_4$ | 0.08 | 90 | 150 | 125 | 270 | Passed | Passed |
| Example 6 | Silica | 300 | $KMnO_4$ | 0.08 | 90 | 150 | 125 | 270 | Passed | Passed |
| Comparative Example 1 | Silica | 0 | $KMnO_4$ | 0.08 | 100 | 500 | 100 | 300 | Passed | Failed |
| Comparative Example 2 | Silica | 500 | $KMnO_4$ | 0.08 | 90 | 200 | 150 | 300 | Failed | Failed |

EP 4 130 190 A1

Table 2

| | Particle | | Oxidant | | Metal salt | | Friction coefficient (relative value) | | Polishing removal rate (relative value) | | Surface roughness | |
|---|---|---|---|---|---|---|---|---|---|---|---|---|
| | Species | Content [ppm] | Species | Concentration [mol/L] | Species | Concentration [mol/L] | Low pressure | High pressure | Low pressure | High pressure | Low pressure | High pressure |
| Example 7 | Silica | 50 | $KMnO_4$ | 0.08 | Ca $(NO_3)_2$ | 0.0125 | 100 | 190 | 130 | 260 | Passed | Passed |
| Example 8 | Silica | 200 | $KMnO_4$ | 0.08 | Ca $(NO_3)_2$ | 0.0125 | 95 | 160 | 135 | 290 | Passed | Passed |
| Example 9 | Silica | 300 | $KMnO_4$ | 0.08 | Ca $(NO_3)_2$ | 0.0125 | 95 | 160 | 135 | 290 | Passed | Passed |

As shown in Table 1, the polishing compositions in Examples 1 to 6, which contains the particles and the oxidant and has a content of the particles of less than 400 ppm, resulted in a reduced friction coefficient in high pressure as well as excellent surface quality of a polished surface, compared to the polishing composition in Comparative Example 1, which contains no particle. Examples 1 to 6 also exhibited excellent surface quality in low pressure and high pressure, compared to Comparative Example 2, which had a content of the particles of 500 ppm.

As shown in Table 2, the polishing compositions in Examples 7, 8, and 9, which contain a metal salt in addition to the polishing compositions in Examples 2, 5, and 6, further improved a polishing removal rate, respectively compared to the examples containing no metal salt.

These results suggests that, in polishing of a high hardness material such as SiC, the polishing composition disclosed herein allows yielding a smooth polished surface comparable with or more than an abrasive-free polishing composition, and can be preferably used in both of a low pressure condition and a high pressure condition.

While specific examples of the present invention have been described above in detail, these are only illustrative, and do not limit the scope of the claims. The technologies recited in the claims include various modifications and alternations of the specific examples illustrated above.

**Claims**

1.  A polishing composition for polishing a material having a Vickers hardness of 1500 Hv or more, the polishing composition comprising:

    particles and an oxidant,
    wherein the content of the particles is less than 400 ppm.

2.  The polishing composition according to claim 1, wherein the average aspect ratio of the particles is 1.5 or less.

3.  The polishing composition according to claim 1 or 2, wherein the particles are silica particles.

4.  The polishing composition according to any one of claims 1 to 3, wherein the oxidant is permanganate.

5.  The polishing composition according to any one of claims 1 to 4, further comprising a metal salt A.

6.  The polishing composition according to claim 5, wherein the metal salt A is calcium nitrate.

7.  The polishing composition according to any one of claims 1 to 6, wherein the material having a Vickers hardness of 1500 Hv or more is silicon carbide.

8.  A polishing method comprising polishing a material having a Vickers hardness of 1500 Hv or more using the polishing composition according to any one of claims 1 to 7.

## INTERNATIONAL SEARCH REPORT

International application No.

PCT/JP2021/010795

### A. CLASSIFICATION OF SUBJECT MATTER
C09K 3/14(2006.01)i; H01L 21/304(2006.01)i
FI: C09K3/14 550Z; C09K3/14 550D; H01L21/304 622D; H01L21/304 622W

According to International Patent Classification (IPC) or to both national classification and IPC

### B. FIELDS SEARCHED

Minimum documentation searched (classification system followed by classification symbols)
C09K3/14; H01L21/304

Documentation searched other than minimum documentation to the extent that such documents are included in the fields searched

| | |
|---|---|
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X<br>A | JP 2017-510977 A (CABOT MICROELECTRONICS CORPORATION) 13 April 2017 (2017-04-13) claims 1-24, paragraphs [0001], [0013]-[0031], examples 1, 5 | 1-3, 5, 8<br>4, 6-7 |
| X<br>A | WO 2015/045757 A1 (FUJIMI INCORPORATED) 02 April 2015 (2015-04-02) claims 1-5, paragraphs [0016]-[0081], in particular, paragraph [0020], examples 34-37 | 1-3, 8<br>4-7 |
| A | JP 2007-27663 A (FUJIMI INCORPORATED) 01 February 2007 (2007-02-01) claims 1-4 | 1-8 |
| A | WO 2017/212971 A1 (MITSUI MINING & SMELTING CO., LTD.) 14 December 2017 (2017-12-14) claims 1-11 | 1-8 |
| A | JP 2015-199838 A (YAMAGUCHI SEIKEN KOGYO KK) 12 November 2015 (2015-11-12) claims 1-7 | 1-8 |

☒ Further documents are listed in the continuation of Box C.  ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 10 June 2021 (10.06.2021) | 22 June 2021 (22.06.2021) |

| Name and mailing address of the ISA/ | Authorized officer |
|---|---|
| Japan Patent Office<br>3-4-3, Kasumigaseki, Chiyoda-ku,<br>Tokyo 100-8915, Japan | Telephone No. |

Form PCT/ISA/210 (second sheet) (January 2015)

**INTERNATIONAL SEARCH REPORT**

| International application No. |
|---|
| PCT/JP2021/010795 |

C (Continuation). DOCUMENTS CONSIDERED TO BE RELEVANT

| Category* | Citation of document, with indication, where appropriate, of the relevant passages | Relevant to claim No. |
|---|---|---|
| A | JP 2015-229750 A (KONICA MINOLTA, INC.) 21 December 2015 (2015-12-21) claims 1-4 | 1-8 |
| A | WO 2012/147605 A1 (ASAHI GLASS CO., LTD.) 01 November 2012 (2012-11-01) claims 1-6 | 1-8 |
| A | WO 2019/138846 A1 (FUJIMI INCORPORATED) 18 July 2019 (2019-07-18) claims 1-10 | 1-8 |

Form PCT/ISA/210 (continuation of second sheet) (January 2015)

**INTERNATIONAL SEARCH REPORT**
Information on patent family members

| International application No. |
| --- |
| PCT/JP2021/010795 |

| Patent Documents referred in the Report | Publication Date | Patent Family | Publication Date |
| --- | --- | --- | --- |
| JP 2017-510977 A | 13 Apr. 2017 | WO 2015/120269 A1 claims 1-24, paragraphs [0017]-[0036], examples 1, 5 EP 3103133 A1 KR 10-2017-0128063 A CN 106062931 A | |
| WO 2015/045757 A1 | 02 Apr. 2015 | US 2016/0215170 A1 claims 1-5, paragraphs [0016]-[0097], in particular, paragraphs [0020]-[0021], examples 34-37 JP 2015-67752 A EP 3053979 A1 CN 105593331 A KR 10-2016-0063331 A TW 201518490 A | |
| JP 2007-27663 A | 01 Feb. 2007 | US 2007/0021040 A1 claims 1-13 KR 10-2007-0012209 A | |
| WO 2017/212971 A1 | 14 Dec. 2017 | CN 109392311 A | |
| JP 2015-199838 A | 12 Nov. 2015 | (Family: none) | |
| JP 2015-229750 A | 21 Dec. 2015 | (Family: none) | |
| WO 2012/147605 A1 | 01 Nov. 2012 | US 2014/0057438 A1 claims 1-6 CN 103493183 A KR 10-2014-0012135 A TW 201250812 A | |
| WO 2019/138846 A1 | 18 Jul. 2019 | TW 201932555 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020060778 A
- JP 2011513991 A

- WO 2012147605 A